# EUROPEAN PATENT APPLICATION

(11) **EP 4 679 122 A1**
(43) Date of publication of application: **14.01.2026**
(21) Application number: 24188175.4
(22) Date of filing: 12.07.2024
(51) Int. Cl.: G01R 33/48, G01R 33/561, G01R 33/56, G01R 33/565

(54) **GRADIENT ECHO IMAGING WITH COMPENSATION OF GEOMETRIC DISTORTIONS**

(71) Applicant: Koninklijke Philips N.V., 5656 AG Eindhoven (NL)
(72) Inventor: BECK, Gabriele, Eindhoven (NL)
(74) Representative: Philips Intellectual Property & Standards

(57) **Abstract**

The invention discloses a method of magnetic resonance imaging of an object (10), comprising: acquiring gradient echo signals from the object (10) using a multi-shot or multi-acquisition echo planar imaging, EPI, sequence, wherein each shot (21-24) or acquisition corresponds to a different k-space segment, wherein the different k-space segments only partially overlap in a central portion of k-space; deriving geometry distortion information by combining the echo signals of different shots (21-24) or acquisitions; and reconstructing a magnetic resonance, MR, image by combining the echo signals of the multiple shots (21-24) or acquisitions, correcting for motion between the different shots (21-24) or acquisitions based on the overlap of the different k-space segments, and using the geometry distortion information to reduce geometric distortions in the reconstructed MR image. An imaging system is further disclosed, comprising a computational system configured to perform the method.

## Description

### FIELD OF THE INVENTION

The invention relates to the field of magnetic resonance (MR) imaging. It concerns a method of MR imaging of an object. The invention also relates to an MR system and to a computer program to be run on an MR system.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects, do not require ionizing radiation and are usually not invasive.

MR imaging is sensitive to diffusion. Known diffusion-weighted imaging (DWI) techniques are commonly performed by using imaging sequences comprising diffusion gradients, wherein the diffusion of protons (of water molecules) along the direction of the diffusion gradient reduces the amplitude of the acquired MR signals.

In general, diffusion-weighted MR imaging techniques acquire multiple diffusion-weighted images, in which additional diffusion-encoding (or diffusion-weighting) magnetic field gradients of different strengths and/or directions are applied prior to the signal readout. The diffusion-encoding gradients provide sensitivity to diffusion of water molecules along respective spatial direction. The amount of this diffusion weighting is related to the amplitude and duration of the additional gradients, which may be characterized with the so-called b-value. In addition to acquiring diffusion-weighted images, a diffusion-weighted imaging sequence will routinely acquire magnetic resonance signals without diffusion weighting, which may be referred to as a "b=0" image, or non-diffusion-weighted image. This b=0 image can be used as a normalization factor when computing apparent diffusion coefficient (ADC) maps, or other diffusion parameter maps.

Diffusion tensor imaging (DTI) is a more sophisticated form of DWI, which allows for the determination of both the magnitude and the directionality of diffusion. For example, DTI enables to visualize white matter fibers in MR brain imaging and can map subtle changes in the white matter associated with diseases like brain infarction, multiple sclerosis, epilepsy etc.

DWI techniques are particularly vulnerable to macroscopic patient motion, as the signal attenuation resulting from the motion in the presence of the diffusion gradients can confound the measurement of interest. Subject motion during an MR imaging examination can be particularly problematic in populations like children, the elderly, or patients with medical conditions that prevent them from lying still.

Due to the need for collecting multiple diffusion-weighted images, as well as b=0 images, within a clinically feasible timeframe, diffusion-weighted MR imaging often utilizes an echo planar imaging (EPI) readout strategy. A single-shot EPI sequence covers the entire required k-space region after a single RF excitation pulse and thus encodes the entire image information within a very short period of time. This reduces the sensitivity to patient motion. However, the image quality can be low and the spatial resolution is limited in single-shot diffusion-weighted EPI. These resolution losses and also geometric distortions (see below) are mainly caused by main magnet field inhomogeneities (B₀) and T₂*- and/or T₂-relaxation during the readout.

Recent efforts have been made to address these limitations of single-shot DWI and increase the spatial resolution by employing multi-shot EPI. In contrast to single-shot EPI, multi-shot EPI divides the acquisition of k-space into several "shots". Each shot corresponds to a separate RF excitation, after which a subset of k-space lines is sampled which together complete the full k-space region required for image formation. The division into multiple shots enables increasing the spatial image resolution. The readout duration of the individual shots is shorter than the readout duration of a single-shot EPI acquisition.

While multi-shot DWI EPI offers several advantages, it is also significantly more sensitive to patient motion between shots. Motion-induced misalignment of the k-space segments covered by the individual shots leads to image artifacts.

As said, severe geometric distortions impair image quality. Such geometric distortions are caused by main magnetic field inhomogeneities and by field distortions induced by eddy currents. EPI requires rapid switching of magnetic field gradients causing a particularly high level of eddy currents. Geometric distortions are not only an issue in the context of diffusion-weighted imaging, but affect different kinds of (gradient echo) imaging techniques. Gradient and spin echo imaging (GRASE) and readout-segmented EPI allow to mitigate the effect of main magnetic field inhomogeneities. Readout segmentation has been suggested as an approach for high resolution diffusion-weighted imaging (DWI). In the readout-segmented EPI scheme, segments of k-space are acquired along the readout direction. This reduces geometric distortions due to the decrease in readout time.

In the diagnosis of head/neck cancer by MR imaging, the regions close to the tongue are crucial for early detection and follow up. Air and dental implants however provide a high local B₀ field disturbance that leads to particularly pronounced geometric distortions when applying (single or multi-shot) DWI EPI. On the other hand, geometry accuracy is crucial not only for precision in diagnosis but also for radiation therapy planning.

Also known is multi-acquisition EPI, which involves acquiring multiple EPI images with slight variations in the acquisition parameters (e.g., phase encoding direction or echo time). These multiple acquisitions can be combined to improve image quality and reduce artifacts. By acquiring multiple images with different geometric distortions, it is possible to use post-processing techniques to correct for these distortions. This correction can significantly enhance the spatial accuracy of the images.

### SUMMARY OF THE INVENTION

From the foregoing it is readily appreciated that there is a need for an improved MR imaging technique. It is an object of the invention to enable motion-resistant MR imaging, in particular DWI EPI, with a reduced level of geometric distortions.

In accordance with the invention, a method of MR imaging of an object placed in an examination volume of an MR system is disclosed. The method comprises the steps of:
- acquiring gradient echo signals from the object using a multi-shot or multi-acquisition EPI imaging sequence, wherein each shot or acquisition corresponds to a different k-space segment, wherein the different k-space segments only partially overlap in a central portion of k-space;
- deriving geometry distortion information by combining the echo signals of different shots or acquisitions; and
- reconstructing an MR image by combining the echo signals of the multiple shots or acquisitions, correcting for motion between the different shots or acquisitions based on the overlap of the different k-space segments, and using the geometry distortion information to reduce geometric distortions in the reconstructed MR image. The object as referred to in the disclosure of the invention may be a portion of the body of a subject, e.g., a patient.

The invention enables fast multi-shot or multi-acquisition EPI imaging with shot-to-shot/acquisition-to-acquisition motion-correction and correction for geometric distortions by acquiring the echo signals from different overlapping k-space segments. The acquisition of the echo signals from the different k-space segments has the effect that the geometric distortions are reflected differently in the echo signals of the different shots/acquisitions. This makes it possible to identify the geometric distortions and distinguish them from the actual "true" image information. The distortion information can thus be derived from the echo signals and used for a corresponding correction in the reconstruction of the MR image.

The geometry distortion information may be derived in the form of one or more geometry distortion maps representing the spatial deviations between the actual locations of anatomical structures and their apparent locations in the distorted MR images. These deviations are typically caused by magnetic field inhomogeneities, gradient nonlinearities, and susceptibility differences within the examined object.

In possible embodiments, the imaging sequence may be a readout-segmented echo planar imaging sequence (RS-EPI), or a gradient and spin echo imaging (GRASE) sequence, which is also considered as an EPI-type imaging sequence within the meaning of the invention.

In a possible embodiment, a phase-encoding polarity of the imaging sequence is varied across the multiple shots or acquisitions, wherein the geometry distortion information is derived by combining the echo signals of different shots or acquisitions associated with different phase-encoding polarities respectively. In this embodiment, the invention applies a variation of the (alternating or nearly opposed) phase-encoding polarity of the imaging sequence across the multiple shots or acquisitions ("blip up-down"). The phase-encoding polarity may be alternated between temporally successive shots or acquisitions. The immediate succession of blip-up and blip-down acquisitions minimizes motion effects between the two acquisitions so that a negative impact of patient motion on the determination of the geometry distortion maps is minimized. The phase-encoding polarity means the (positive or negative) direction of the phase-encoding magnetic field gradient blips of the EPI-type imaging sequence.

As explained above, B₀ inhomogeneities, often exacerbated by eddy current effects any by the patient's own biological tissues (especially near air-tissue interfaces or near dental implants in head imaging), cause local frequency-shifts in the proton nuclear resonance. This results in spatial misregistration in the phase-encoding direction, leading to the mentioned geometric distortions in the final MR image. The alternating of the phase-encoding polarity (also referred to as "blip up-down acquisition") applied according to the invention aims to correct for these distortions by acquiring two separate sets of echo signals with opposite phase-encoding directions. The alternation of the phase-encoding polarity results in an equal but opposite distortion in the "blip-up" acquisitions compared to the "blip-down" acquisitions. Intermediate blip-up MR images can be reconstructed from the echo signals of shots with a positive phase-encoding polarity while intermediate blip-down MR images can be reconstructed from the echo signals of shots with a negative phase-encoding polarity. Each voxel from an intermediate blip-up image can then be compared with its corresponding voxel in the intermediate blip-down image. Because the distortions are opposite, it is possible to clearly identify and determine the geometric distortions and to derive corresponding geometric distortion maps by combining the echo signals of shots with different (opposed or nearly opposed) phase-encoding polarities. Sophisticated algorithms can be used to precisely model the distortions based on the differences observed between each pair of acquisitions with positive and negative phase-encoding polarities respectively.

The imaging sequence may use diffusion-weighting such that the MR image reconstructed from the acquired gradient echo signals is diffusion-weighted. In combination with the determination and reduction of geometric distortions, the invention thereby provides a diffusion-weighted multi-shot/multi-acquisition EPI imaging technique as a powerful technique for high resolution and low geometric distortion diffusion imaging that is of especially high demand in head imaging applications.

In a further possible embodiment, the method comprises the determination of a B0 map which is included in the derivation of the geometry distortion information. The B0 map can be used in the image reconstruction step to further improve the reduction of geometric distortions. The B0 map can be obtained by a separate acquisition (e.g., in a pre-scan step). Alternatively, the B0 can be intrinsically derived from the acquired echo signals generated by the multi-shot/multi-acquisition imaging sequence using a Dixon technique, i.e. by applying temporal shifts of the echo signals in a targeted fashion. With the additional B0 map, a very precise distortion correction can be accomplished.

In another possible embodiment, the imaging sequence is an echo planar imaging sequence (EPI), a readout-segmented echo planar imaging sequence (RS-EPI), or a gradient and spin echo imaging (GRASE) sequence. These gradient echo-based fast imaging sequences benefit in particular from the invention's approach to reducing geometric distortions. In yet another embodiment, the k-space segments are k-space blades according to a periodically rotated overlapping parallel lines with enhanced reconstruction (PROPELLER) scheme, wherein k-space blades sampled by the gradient echo signals of different shots are rotated relative to each other about the center of k-space. The PROPELLER imaging scheme employed by this embodiment of the invention offers advantages like robustness against patient motion and intrinsic motion compensation capabilities. In the PROPELLER concept known as such in the art (see Pipe et al, Magnetic Resonance in Medicine, 42:963-969, 1999), magnetic resonance signals data are acquired in k-space in N strips, each consisting of L parallel k-space lines, corresponding to the L lowest frequency phase-encoding lines in a Cartesian-based k-space sampling scheme. Each of the k-space lines corresponds to one echo signal generated by the EPI sequence in accordance with the invention. The strips, which are referred to herein as k-space blades, are rotated relative to each other in k-space by an angle of, e.g., 180°/N, so that the total set of magnetic resonance signals spans a circle in k-space. One essential characteristic of PROPELLER is that a central circular portion in k-space, having a diameter L, is acquired for each k-space blade. This central portion can be used to reconstruct a (low-resolution) intermediate single-blade MR image for each k-space blade. The single-blade MR images can be compared to each other to estimate and compensate for patient motion. This is how correction for motion between the acquisitions of the multiple shots can be performed in the step of reconstructing the (diffusion weighted) MR image in the method of the invention. Thus, the PROPELLER technique makes use of oversampling in the central portion of k-space in order to obtain an acquisition technique that is robust with respect to motion of the examined patient during signal acquisition. However, the described general concept of motion-correction based on the overlap of the different k-space segments is applicable regardless of the type of acquisition, i.e. regardless of the application of the PROPELLER scheme.

Due to averaging of k-space blades, PROPELLER to a certain extent "averages out" different types of imaging artefacts which is a further benefit of the PROPELLER technique. It is particularly the combination of the PROPELLER technique with the variation of the phase-encoding polarity across the multiple shots or acquisitions (blip up-down scheme) which allows to obtain a (high resolution) multi-shot gradient echo imaging technique with high motion-robustness and an effective correction of geometry distortions.

By exploiting the advantages of the PROPELLER scheme it is even possible to align the geometry distortion information by correction for motion between the different shots or acquisitions.

In another possible embodiment, each k-space segment is acquired at least twice, once with positive and once with negative phase-encoding polarity. In this case, the deriving of the geometry information from the pairs of k-space segment acquisitions is straight forward. However, in the case of PROPELLER imaging, it is principally also possible to acquire k-space blades with adjacent rotation angles with alternating phase-encoding polarities. The rotation between individual intermediate single-segment/single-blade images can be compensated for, and the derivation of geometry distortion information is still possible with sufficient accuracy from the respective pairs of acquisitions.

More generally, in possible embodiments, an intermediate single-segment MR image is reconstructed from the acquired echo signals for each k-space segment. The single-segment MR images can be aligned for motion-correction by exploiting the sampling of the central portion of k-space by all k-space segments. Geometric distortions in the single-segment MR images can then be reduced using the geometry distortion information. The final MR image can be reconstructed by combining the intermediate single-segment MR images after motion correction and reduction of geometric distortions of the single-segment MR images. However, it also possible to reconstruct the final MR image directly from k-space data provided by the joint echo signals of all of the multiple shots or acquisitions.

All single-segment MR images, geometry distortion maps and the B₀ map can be aligned for motion-compensation based on the oversampling of the central portion of k-space covered by all k-space segments.

The B₀ map and the individual intermediate blip-up and blip-down MR images can be combined to derive the geometry distortion information, wherein the respective blip up-down pairs of intermediate MR images can be used to estimate additive distortions not predicted by the B₀ map alone.

In a possible embodiment, the intermediate blip-up images may be reconstructed from echo signals acquired from other k-space segments than the echo signals from which the intermediate blip-down images are reconstructed.

In strongly distorted image regions where no useful information is retrievable at all, the image information from other k-space blades can be weighted more strongly. This can be achieved by various filtering and/or compressed sensing weighting approaches, such as the known KWIC filtering approach. Furthermore, deep learning or other artificial intelligence approaches can be used to synthesize those distorted regions based on the image content from other k-space segments/blades.

In an alternative embodiment, the (diffusion weighted) MR image can be reconstructed directly from the k-space data provided by the joint echo signals of the multiple shots (joint segment/blade reconstruction). A deep learning or other artificial intelligence (AI)-based reconstruction algorithm can be used for this purpose.

Generative adversarial network (GAN) or cyclic generative adversarial network (CycleGAN) algorithms are well-suited to synthesize a complete distortion-free MR image from the acquired gradient echo signals, providing effective constraints from the different acquired k-space segments, phase-encoding polarities and/or blade orientations in the case of PROPELLER imaging. With the GAN or cyclic GAN method, distorted MR images may be reconstructed initially and, based on the distortion information and/or further individual inputs, a "true" distortion-free MR image can be computed.

In addition to geometric distortion maps also eddy currents may be estimated from the different acquisitions and could be fed as input to the GAN or CycleGAN algorithms. Such an algorithm can be trained to reconstruct the final MR image and to simultaneously correct for motion and geometric distortions based on the segmented k-space acquisition and blip up-down gradient echo acquisition in accordance with the invention. A so-called super-resolution AI-based technique can be used advantageously to reconstruct high resolution MR images from acquisitions of different k-space segments (with different k-space coverage) with the identical spatial resolution. Together with the B₀ map and the blip-up, blip-down acquisition, a distortion-free MR image can be reconstructed. Such super-resolution AI-based techniques are well-suited to reconstruct a final high-resolution (diffusion-weighted) MR image.

The method of the invention described thus far can be carried out by means of an MR system including at least one main magnet coil for generating a uniform static magnetic field within an examination volume, a number of gradient coils for generating switched magnetic field gradients in different spatial directions within the examination volume, at least one RF coil for generating RF pulses within the examination volume and/or for receiving MR signals from an object positioned in the examination volume, a control unit for controlling the temporal succession of RF pulses and switched magnetic field gradients, and a reconstruction unit. The method of the invention can be implemented, for example, by a corresponding programming of the reconstruction unit and/or the control unit of the MR system.

The method of the invention can be advantageously carried out in most MR devices in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR system for carrying out the method of the invention;
Fig. 2 shows a diagram of an imaging sequence used in an embodiment of the invention;
Fig. 3 illustrates the PROPELLER acquisition by the imaging sequence of Fig. 2;
Fig. 4 illustrates an acquisition of different k-space segments according to another embodiment of the method of the invention.

### DETAILED DESCRIPTION OF THE EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

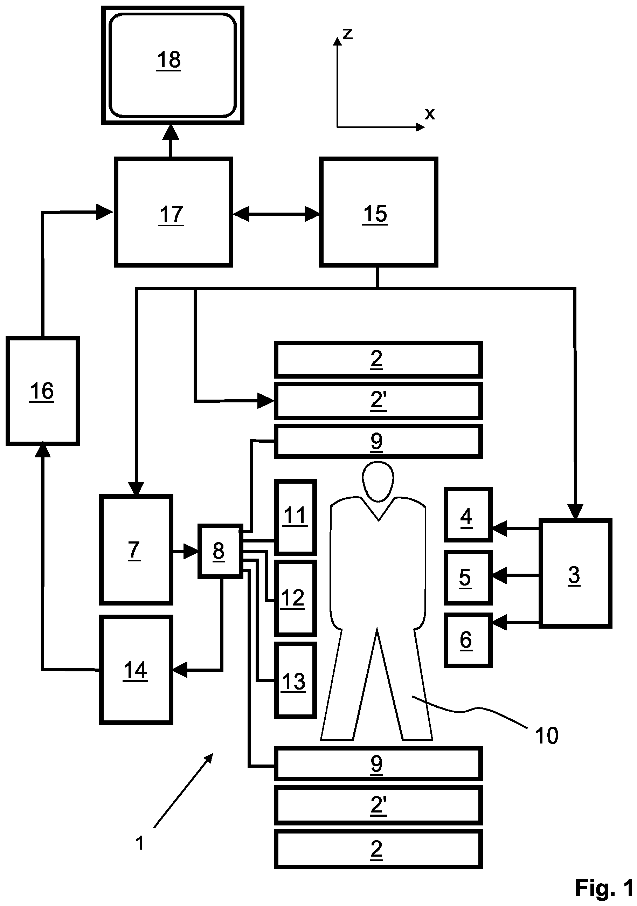

With reference to Fig. 1, an MR system 1 is shown. The system comprises superconducting or resistive main magnet coils 2 such that a substantially uniform, temporally constant main magnetic field is created along a longitudinal (z-axis) through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging. More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a whole-body volume RF coil 9 to transmit RF pulses into the examination volume. A typical MR imaging sequence is composed of a packet of RF pulse segments of short duration, which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the whole-body volume RF coil 9.

For generation of MR images of limited regions of the body 10, a set of local array RF coils 11, 12, 13 are placed contiguous to the region selected for imaging. The array coils 11, 12, 13 can be used to receive MR signals induced by body-coil RF transmissions.

The resultant MR signals are picked up by the whole-body volume RF coil 9 and/or by the array RF coils 11, 12, 13 and demodulated by a receiver 14 preferably including a preamplifier (not shown). The receiver 14 is connected to the RF coils 9, 11, 12 and 13 via send/receive switch 8.

A host computer 15 controls the gradient pulse amplifier 3 and the transmitter 7 to generate any of a plurality of MR imaging sequences, such as diffusion-weighted echo planar imaging (DWI EPI) or the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR systems, the data acquisition system 16 is a separate computer, which is specialized in acquisition of raw image data.

Ultimately, the digital raw image data is reconstructed into an image representation by a reconstruction processor 17, which applies a Fourier transform or other appropriate reconstruction algorithms, such as SENSE or SMASH. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor or display screen 18, which provides a human-interpretable display of the resultant MR image.

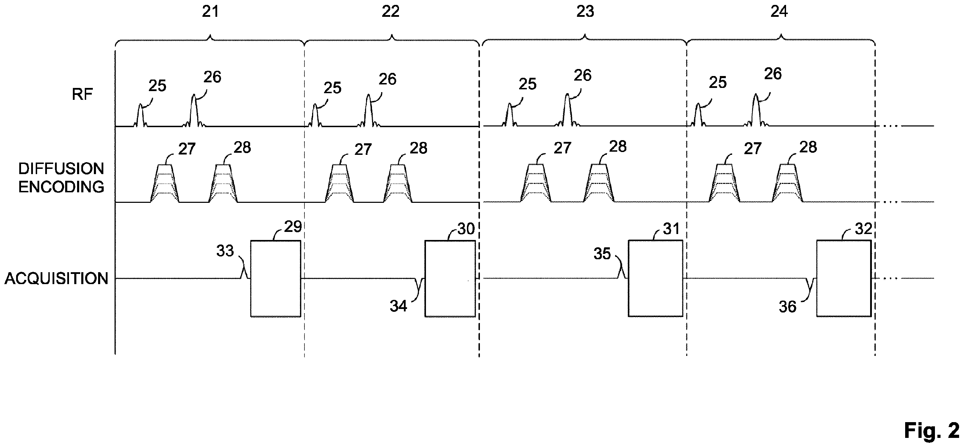

With continuing reference to Fig. 1 and with further reference to Figs 2, 3 and 4 an embodiment of the invention is explained in the following.

A diffusion-weighted EPI acquisition is implemented by the imaging sequence illustrated in Fig. 2. Each of the shots 21, 22, 23, 24 includes an RF excitation pulse 25 followed by an RF refocusing pulse 26. A first diffusion-encoding gradient 27 is generated before the refocusing pulse 26 and a second diffusion-encoding gradient 28 is generated after the refocusing pulse 26 and before the EPI readouts 29, 30, 31, 32 of the respective shots 21, 22, 23, 24. While only four shots 21, 22, 23, 24 of the imaging sequence are shown in Fig. 2, the sequence will contain further shots in practice (indicated by the dashed lines on the right). As many shots of the multi-shot EPI sequence are applied as necessary in accordance with the respective imaging task to sample the required k-space region by the echo signals generated by the EPI sequence.

The amplitude, duration, spacing, and/or polarity of the diffusion-encoding gradients 27, 28 can be varied in different repetitions of the pulse sequence in order to provide different diffusion weightings. By applying diffusion-encoding gradients 27, 28 along different spatial directions, the diffusion-encoding is sensitive to diffusion occurring along the respective spatial directions.

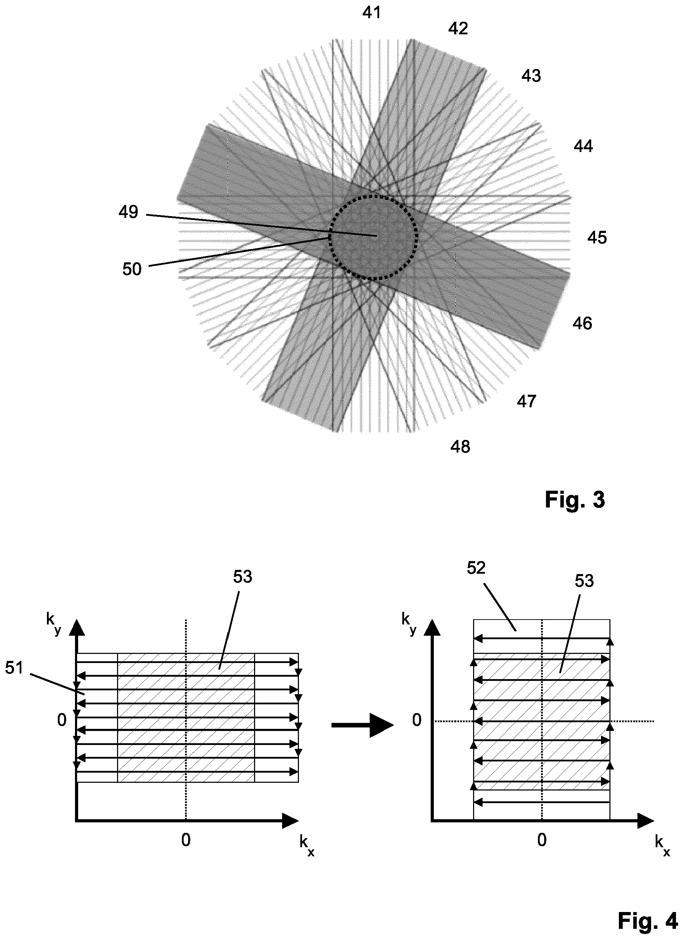

Each shot of the imaging sequence shown in Fig. 2 samples a k-space segment. In one possible example, this k-space segment can be a k-space blade according to a PROPELLER scheme, wherein k-space blades (41-48, see Fig. 3) sampled by the echo signals of different shots are rotated relative to each other about the center 49 of k-space. In the EPI acquisition of each k-space blade 41-48, the phase-encoding direction is oriented along the short axis of the respective k-space blade 41-48 while the readout (frequency-encoding) direction is oriented along the long axis of the respective k-space blade 41-48. However, a so-called short-axis PROPELLER acquisition, in which the phase-encoding direction is oriented along the long axis of the respective k-space blade 41-48 while the readout (frequency-encoding) direction is oriented along the short axis of the respective k-space blade 41-48, is also conceivable in principle.

In order to mitigate geometry distortion and achieve high resolution using the depicted multi-shot EPI scheme, the phase-encoding polarity of the EPI readouts 29, 30, 31, 32 is varied across the multiple shots 21, 22, 23, 24. Alternating shots sample k-space with opposite (or nearly opposite) phase-encoding polarities ("blip-up" and "blip-down"). In the embodiment, the polarity of the schematically shown phase-encoding gradient blips 33, 35 is positive ("blip-up") in the shots 21, 23 while the polarity of the phase-encoding gradient blips 34, 36 is negative ("blip-down") in the shots 22, 24. This interleaved pattern is repeated correspondingly while sampling the whole circular k-space region along k-space blades 41-48.

In the exemplary embodiment, each k-space blade 41-48 is acquired twice, once with positive and once with negative phase-encoding direction. As an example, shots 21, 22 each sample k-space blade 42 with opposite phase-encoding polarities, while shots 23, 24 each sample k-space blade 46 also with opposite phase-encoding polarities.

Another option would be to acquire every second k-space blade (e.g., k-space blades 41, 43) with a blip down phase-encoding polarity relative to the k-space blades lying in between them respectively (e.g., k-space blade 42) and use this for distortion correction.

Intermediate single-blade blip-up and blip-down MR images are reconstructed from the echo signals of the respective shots 21-24. As an example, a parallel image reconstruction technique, such as a SENSE reconstruction, can be used for this intermediate reconstruction. The intermediate single-blade blip-up and blip down MR images have opposite geometric distortions caused by inhomogeneity of the main magnetic field due to the opposite phase-encoding directions. This is exploited for deriving geometry distortion maps from the intermediate single-blade blip-up and blip-down images for each k-space blade 41-48. The geometry distortion maps as well as the intermediate single-blade blip-up and blip-down MR images are aligned for motion-correction based on the oversampling of the central portion 50 of k-space by the PROPELLER scheme. Intermediate single-blade MR images that are corrected for geometry distortions are then computed by combining the single-blade blip-up and blip-down MR images for each k-space blade 41-48 and by using the respective geometry distortion maps.

Finally, a high-resolution diffusion-weighted MR image is reconstructed by combining the thus distortion-corrected and motion-corrected intermediate single-blade MR images using a suitable reconstruction framework.

In order to further improve the reduction of geometric distortions, a B₀ map can be acquired in a separate step (e.g., by a suitable pre-scan, not depicted). The B₀ map can then be used in the reconstruction of the intermediate single-blade MR images and/or in the final image reconstruction.

The reconstruction of the final diffusion-weighted MR image can also be performed by incorporating the geometry distortion maps and the B₀ map into a more advanced reconstruction technique, such as an AI-based joint reconstruction algorithms, which computes the MR image directly from the full set of acquired echo signals of all k-space blades 41-48 (and the B₀ map). The thus reconstructed diffusion-weighted MR image can then be displayed to a user via a display screen or video monitor 18 or stored for later use. Diffusion-weighted MR images reconstructed in the described fashion for different b-values can be processed to generate quantitative parameter maps, such as apparent diffusion coefficient or intravoxel incoherent motion (IVIM) maps.

The illustrated combination of the PROPELLER sampling scheme with the blip up-down acquisition provides a high-resolution multi-shot DWI EPI technique with good motion-robustness and an effective correction of geometry distortions.

Fig. 4 shows k-space diagrams illustrating k-space sampling by two successive shots or acquisitions of an EPI imaging sequence. A k-space segment 51 stretched in the kₓ-direction is sampled by a first shot/acquisition (left diagram), a k-space segment 52 stretched in the k_{y}-direction is sampled by a second shot/acquisition (right diagram). In this way, the two shots/acquisitions correspond to different k-space segments 51, 52 (which differ from each other with regard to their respective k-space coverage). The different k-space segments only partially overlap in the central k-space region 53 (diagonally hatched). The phase-encoding polarities (indicated by vertically pointing arrows) used in the two acquisitions are opposed. A final MR image free of geometric distortions is reconstructed (synthesized) from the two acquisitions and, optionally, from a separately acquired B₀ map using a GAN AI method. The different k-space coverages and different phase-encoding polarities result in different (and reverse) geometry distortions. These (in combination with the B₀ map) can be identified by the correspondingly trained GAN method to reconstruct the distortion-free MR image.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

## Claims

1. A method of magnetic resonance imaging of an object (10), comprising:
acquiring gradient echo signals from the object (10) using a multi-shot or multi-acquisition echo planar imaging, EPI, sequence, wherein each shot (21-24) or acquisition corresponds to a different k-space segment, wherein the different k-space segments only partially overlap in a central portion of k-space;
deriving geometry distortion information by combining the echo signals of different shots (21-24) or acquisitions; and
reconstructing a magnetic resonance, MR, image by
combining the echo signals of the multiple shots (21-24) or acquisitions,
correcting for motion between the different shots (21-24) or acquisitions based on the overlap of the different k-space segments, and
using the geometry distortion information to reduce geometric distortions in the reconstructed MR image.

2. The method of claim 1, wherein a phase-encoding polarity of the imaging sequence is varied across the multiple shots (21-24) or acquisitions, wherein the geometry distortion information is derived by combining the echo signals of different shots (21-24) or acquisitions with different phase-encoding polarities.

3. The method of claim 1 or 2, further comprising determining a B₀ map which is included in deriving the geometry distortion information.

4. The method of any one of claims 1 to 3, wherein the imaging sequence uses diffusion-weighting, and the MR image reconstructed from the acquired gradient echo signals is diffusion-weighted.

5. The method of any one of claims 1 to 4, wherein the imaging sequence is a readout-segmented echo planar imaging sequence, RS-EPI, or a gradient and spin echo imaging, GRASE, sequence.

6. The method of any one of claims 1 to 5, wherein the k-space segments are k-space blades (41-48) according to a PROPELLER scheme, wherein k-space blades (41-48) sampled by the gradient echo signals of different shots (21-24) or acquisitions are rotated relative to each other about the center (49) of k-space, and wherein optionally, k-space blades (41-48) with adjacent rotation angles are acquired with alternating phase-encoding polarities.

7. The method of claim 6, wherein the geometry distortion information is derived from the echo signals of shots (21-24) or acquisitions with different phase-encoding polarities and/or different rotation angles from the overlapping central portion of k-space.

8. The method of any one of claims 1 to 7, wherein deriving of the geometry distortion information involves:
reconstructing intermediate blip-up MR images from the echo signals of shots (29, 31) or acquisitions with a positive phase-encoding polarity;
reconstructing intermediate blip-down MR images from the echo signals of shots (30, 32) or acquisitions with a negative phase-encoding polarity; and
estimating geometric distortions from the intermediate blip-up and blip-down MR images, and
wherein optionally, the intermediate blip-up images are reconstructed from echo signals acquired from other k-space segments than the echo signals from which the intermediate blip-down images are reconstructed.

9. The method of any one of claims 1 to 8, wherein the geometry distortion information is aligned by correction for motion between the acquisitions of the different shots (21-24) or acquisitions.

10. The method of any one of claims 1 to 9, wherein the phase-encoding polarity is alternated between successive shots (21-24) or acquisitions.

11. The method of any one of claims 1 to 10, wherein each k-space segment is acquired at least twice, once with positive and once with negative phase-encoding direction.

12. The method of any one of claims 1 to 11, wherein an intermediate single-segment MR image is reconstructed from the acquired echo signals for each k-space segment, and wherein optionally, the intermediate single-segment MR images are aligned for motion-correction by exploiting the sampling of the central portion (50) of k-space by all k-space segments.

13. The method of claim 12, wherein geometric distortions in the intermediate single-segment MR images are reduced using the derived geometry distortion information, and wherein optionally, the MR image is reconstructed by combining the intermediate single-segment MR images after motion correction and reduction of geometric distortions of the intermediate single-segment MR images.

14. The method of any one of claims 1 to 13, wherein a deep learning or other artificial intelligence-based reconstruction algorithm, such as a generative adversarial network, GAN, or a cyclic generative adversarial network, CycleGAN, algorithm, is used in the reconstruction of the MR image.

15. An imaging system comprising at least one processor (17) configured to perform a method according to any of the claims 1 to 14.
